# EUROPEAN PATENT APPLICATION

(11) **EP 2 827 096 A1**
(43) Date of publication of application: **21.01.2015**
(21) Application number: 13764685.7
(22) Date of filing: 22.03.2013
(51) Int. Cl.: G01B 5/14, G01B 3/30

(54) **TESTING FINGER**

(30) Priority: 23.03.2012 CN 201220113817 U
(71) Applicant: Schneider Toshiba Inverter Europe SAS, 27120 Pacy sur Eure (FR)
(72) Inventor: YU, Haiyuan, Shanghai 201203 (CN); YAO, Yingnzi, Shanghai 201203 (CN); CAI, Yuanjia, Shanghai 201203 (CN)
(74) Representative: Manitz, Finsterwald & Partner GbR
(86) International application number: PCT/CN2013/073035
(87) International publication number: WO 2013/139296

(57) **Abstract**

A testing finger (1) comprises a finger-shaped rod (2). A sharp end (3) of the finger-shaped rod (2) is connected with a testing part used for measuring a distance. The testing part is a group of testing heads, and the length of each testing head corresponds to minimum safe distances at different voltage levels in intrusion protection. The testing part is connected with the sharp end (3) of the finger-shaped rod (2) in a detachable insertion manner. The testing finger (1) can accurately determine whether the distance between a live part or a live lead which is not insulated in an electrical device and a protective part is greater than or equal to a minimum safety distance, thereby solving the problem in the prior art that the distance between the sharp end (3) of the finger-shaped rod (2) and the live part or the live lead cannot be accurately measured by a clamp in a situation of limited space.

## Description

### BACKGROUND

The present utility model relates to a testing finger, and particularly to a testing finger used for determining whether the intrusion protection level of an electric apparatus meets the safety standard.

In order to depress the danger of electric shock or damage occurred during the operation of an electric apparatus, it's generally required to measure the distance of the uninsulated live part or live lead within the electric apparatus to a protection part, for example, the housing, and determine whether such a distance is greater than or equal to the minimum safe distance, so as to avoid human or other living beings from directly contacting with the uninsulated live part or live lead and thus being subjected to damage.

The method for measuring such a distance in prior art is to place a finger-shaped rod at the position to be measured, then measure the distance from the sharp end of this rod to the live part or live lead using a clamp. In such a measuring method, the clamp is sometimes limited by the space such that it's impossible to carry out an effective measurement. In such a case, the engineer has to visually estimate this distance directly to determine whether the distance is greater than or equal to the minimum safe distance, however, the estimated result is sometimes inaccurate.

### SUMMARY

In order to remedy the deficiency of prior art, the utility model provides a testing finger capable of determining accurately whether such a distance is greater than or equal to the minimum safe distance. This testing finger is used in an electric apparatus for accurately determine whether the distance between the sharp end of the testing finger and the uninsulated live part or live lead is greater than or equal to the minimum safe distance.

The technical solution of the testing finger provided by the utility model is that:

A testing finger comprising a finger-shaped rod, a sharp end (3) of the finger-shaped rod (2) is connected with a testing part used for measuring a distance.

The effect of this finger-shaped rod is identical to that of the finger-shaped rod in prior art, when in use, the sharp end of the finger-shaped rod is used to abut against the housing of an electric apparatus, and the testing part is directly used to test the distance between the sharp end of the finger-shaped rod and the uninsulated live part or live lead. The length of the testing part may be preset and is selected to be the length of the required minimum safe distance, and if the free end of the testing part can contact with the charged body (i.e., the uninsulated live part or live lead), it's demonstrated that the distance is less than or equal to the minimum safe distance, and on the contrary, if the free end can not contact with the charged body, it's demonstrated that the distance is greater than the minimum safe distance, the distance conforms to the safety set standard when it's greater than or equal to the minimum safe distance.

The testing part is generally a group of testing heads, and the length of each testing head corresponds to minimum safe distances at different voltage levels in intrusion protection.

The testing part comprises a joining part for connecting with the sharp end of the finger-shaped rod and a calibration value part for measuring a distance.

On occasions where the voltage levels are different, there exist distinct requirements for the safe distance, the testing head is made to have different calibration length value so that it's possible to satisfy the test under different voltage levels.

The sharp end of the finger-shaped rod is provided with a partially-spherical groove, the bottom of the partially-spherical groove is securely provided with a magnet, and the partially-spherical groove is provided therein with a connection ball made of ferromagnetic materials, the connection ball contacts with the magnet and is attached into the partially-spherical groove via the magnetic connection by the magnet, and the connection ball is provided with an aperture cooperating with the joining part of the testing part, and the joining part of the testing part is inserted into the aperture.The joining part of the testing part is attached with the aperture on the connection ball through interference fit, snapping connection or magnetic connection. With such a connection configuration, the connection ball can freely rotate within the partially-spherical groove in the sharp end of the finger-shaped rod, thus the testing part inserted into the aperture on the connection ball is permitted to freely swing within a certain angle due to the free rotation of the connection ball. The orientation of the testing part can vary freely, which increases the flexibility for the use of the testing finger.

The connection between the testing part and the sharp end of the finger-shaped rod is a detachable insetting connection, thus facilitating the user to replace testing parts of different calibration length according to actually practical voltage.

The joining part of the testing part is attached with the aperture on the connection ball through interference fit, snapping connection or magnetic connection, therefore, the testing part used in the testing is unlikely to fall off from the aperture.

The end of the finger-shaped rod where the sharp end is located is provided at the centre thereof with a groove extending to the outer edge of the finger-shaped rod, and the sharp end of the finger-shaped rod is provided with a partially-spherical groove greater than a half ball, and within the partially-spherical groove, there is provided with a connection ball having a diameter slightly greater than the diameter of the spherical groove, the connection ball is provided with an aperture cooperating with the joining part of the testing part, and the joining part of the testing part is inserted into the aperture.

The bottom of this groove is transited with a cylindrical groove; the diameter of the cylindrical groove is greater than the width of the groove. The joining part of the testing part is attached within the aperture of the ball through interference fit, snapping connection or magnetic connection.

With such a connection configuration, due to the elastic deformation of the through groove provided at the end of the finger-shaped rod where the sharp end thereof is arranged, the ball can be pushed in from outside and snapped within the partially-spherical groove being greater than a half ball, and can also rotate freely, and the ball is unlikely to decoupled from the sharp end of the finger-shaped rod. For the purpose of terseness, the advantage of this connection configuration identical or similar to that of the above connection configuration is omitted here.

The finger-shaped rod is hollow, the sharp end of the finger-shaped rod is rotatably connected to the circular toggle, the toggle rotates around the radial axle of the sharp end of the finger-shaped rod, and the radial edge of the toggle is provided with a projection for cooperating with the testing part, the joining part of the testing part is muff-coupled onto the projection, the toggle is connected with one end of the driver shaft, and the other end of the driver shaft is rotably coupled with the slide bar, and the driver shaft and part of the slide bar are housed within the finger-shaped rod, the slide bar extends beyond the end of the finger-shaped rod.

The joining part of the testing part is attached with the projection through interference fit, snapping connection or magnetic connection.

With such a configuration, when the testing finger is in use, it's possible to alter the orientation of the testing part by pulling or pushing the slide bar, the slide bar then drives the driver shaft, the driver shaft then drives the toggle, and then the toggle drives the testing part on the projection to rotate. Also for the purpose of terseness, the advantage of this connection configuration identical to that of the above two connection configuration is omitted here.

In this configuration, the free end of the slide bar can also threadly fit with the free end of the finger-shaped rod.

When a thread fitting is used to control the sliding of the slide bar, it's possible for the slide bar to slide even more smoothly, thus it's more easily to control the motion of the toggle driven by the slide bar via the driver shaft.

The testing finger submitted by the present utility model overcomes the problem in prior art that, on occasions of limited space, the clamp is unable to accurately measure the distance from the sharp end of the finger-shaped rod to the live part or live lead, and provides good usableness and simpler configuration. The testing finger enables to easily and accurately determine whether the distance from the sharp end of the finger-shaped rod to the live part or live lead meets the safety standard.

### BRIEF DESCRIPTION OF THE DRAWINGS

Further advantages and characteristics of the present utility model will become even more apparent from the following specific embodiments of the present utility model given only by way of non-limiting examples and illustrated in the drawings, in which:

Fig.1(a) is a view of the assembled testing finger according to the first embodiment of the utility model;

Fig.1(b) is an exploded view of the testing finger according to the first embodiment of the utility model;

Fig.1(c) is a sectional view of the testing finger according to the first embodiment of the utility model;

Fig.2(a) is a view of the assembled testing finger according to the second embodiment of the utility model;

Fig.2(b) is a exploded view of the testing finger according to the second embodiment of the utility model;

Fig.2(c) is a sectional view of the testing finger according to the second embodiment of the utility model;

Fig.3(a) is a view of the assembled testing finger according to the third embodiment of the utility model;

Fig.3(b) is a view of the testing finger according to the third embodiment of the utility model having no testing part installed thereon;

Fig.3(c) is a view of the testing finger according to the third embodiment of the utility model and its associated structure.

### Reference numerals:

- 1: testing finger
- 2: finger-shaped rod
- 3: sharp end
- 4: magnets
- 5: connection ball
- 6: calibration value part
- 7: joining part
- 8: connection ball
- 9: projection
- 10: toggle
- 11: driver shaft
- 12: slide bar
- 13: locking pin
- 14: pin hole
- 15: partially-spherical groove
- 16: aperture
- 17: groove

### DETAILED DESCRIPTION

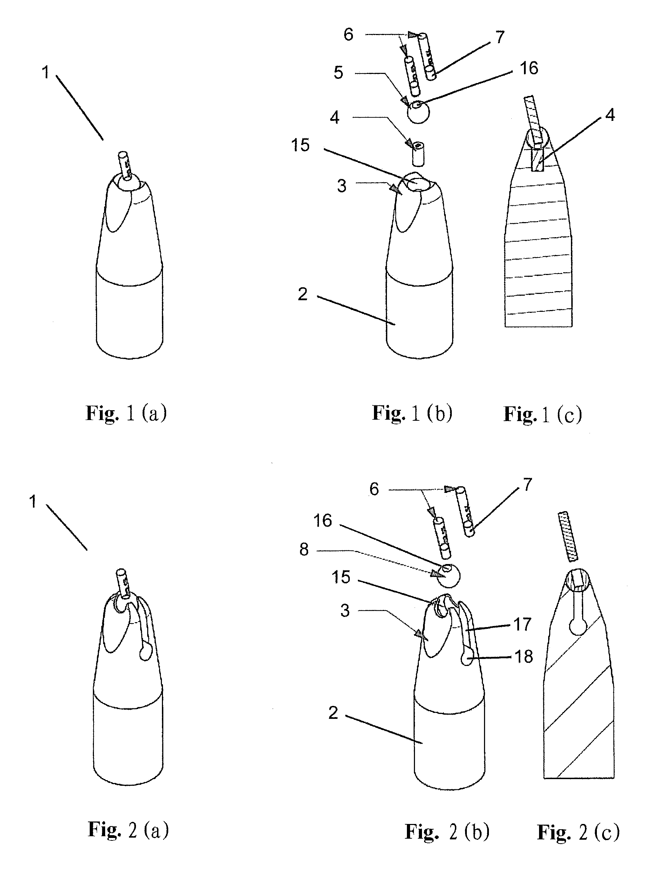

The embodiments of the testing finger of the utility model will be now illustrated in conjunction with Figs 1(a) to 3(c).For the purpose of clarity and simplicity, the same and similar parts in different embodiments will be indicated using identical reference numerals.

The testing finger 1 provided by the present utility model comprises a finger-shaped rod 2, the sharp end 3 of the finger-shaped rod 2 is connected with a testing part. The testing part is comprised of two parts, one of which is the joining part 7 being attached to the sharp end 3 of the finger-shaped rod, and the other one is the calibration value part 6 used for measuring the distance between the sharp end of the testing finger and the uninsulated live part or live wire.

The effect of this finger-shaped rod 2 is identical to that of the finger-shaped rod in prior art, when in use, the sharp end 3 of the finger-shaped rod 2 is used to abut against the housing of an electric apparatus, and the testing part is directly used to test the distance between the sharp end 3 of the finger-shaped rod 2 and the uninsulated live part or live lead. The length of the testing part may be preset and is selected to be the length of the required minimum safe distance, and if the free end of the testing part can contact with the charged body (i.e., the uninsulated live part or live lead), it's demonstrated that the distance is less than or equal to the minimum safe distance, and on the contrary, if the free end can not contact with the charged body, it's demonstrated that the distance is greater than the minimum safe distance, the distance conforms to the safety set standard when it's greater than or equal to the minimum safe distance.

Generally, the testing part is a group of testing heads having different calibration length value, the testing head can be exchangeably used on the sharp end 3 of the finger-shaped rod 2.On occasions where the voltage levels are distinct, there exist distinct requirements for the safe distance, the testing heads are made to have different calibration length values and can be exchanged when in use, such that that it's possible to satisfy the test under different voltage levels.

### Embodiment 1

As shown in Fig.1(b), the sharp end 3 of the finger-shaped rod 2 is provided with a partially-spherical groove 15, the bottom of the partially-spherical groove 15 is securely provided with a magnet 4, and the partially-spherical groove 15 is provided therein with a connection ball 5 made of ferromagnetic materials, the connection ball 5 contacts with the magnet 4 and is attached into the partially-spherical groove 15 through the magnetism of the magnet 4, and the connection ball 5 is provided with a aperture 16 for cooperating with the joining part 7 of the testing part, and the joining part 7 of the testing part is inserted into the aperture 16.

For the purpose of steadily connecting the testing part to the sharp end 3 of the finger-shaped rod 2 and preventing the same from falling off, the joining part 7 of the testing part may also be made of the materials involving magnet, and in this way, due to the magnetic suction force between the joining part 7 and the connection ball 5, the testing part may be steadily connected to the sharp end 3.

For the purpose of connecting the testing part steadily, the joining part 7 of the testing part may also be attached into the aperture 16 in the connection ball 5 through interference fit or snapping connection.

Since the testing part is attached tot he connection ball 5, the connection ball 5 is coupled with the partially-spherical groove 15 through magnetic connection, the connection ball 5 may rotate freely within the partially-spherical groove 15 in the sharp end 3 of the finger-shaped rod 2, therefore, the testing part inserted into the aperture 16 of the connection ball 5 may also rotate freely within a certain angle as the connection ball 5 rotates freely. The orientation of the testing part can vary freely, which increases the flexibility for the use of the testing finger. This angular variation is generally regulated prior the use of the testing finger, and when in use, the orientation of the testing part generally should not be regulated.

The connection of the testing part with the sharp end 3 of the finger-shaped rod 2 is a detachable insertion connection, thus facilitating the replacement of the testing part.

### Embodiment 2

For the sake of simplicity, the advantages identical or similar to that of the connection configuration illustrated in embodiment 1 are omitted here.

As illustrated in Fig.2(b), the sharp end 3 of the finger-shaped rod 2 is provided at the centre thereof with a groove 17 extending to the outer edge of the finger-shaped rod 2, that is, this groove 17 is through groove, and the bottom of the groove 17 is transited with a cylindrical groove 18, the diameter of the cylindrical groove 18 is greater than the width of the groove 17, the sharp end 3 of the finger-shaped rod 2 is provided with a partially-spherical groove 15 which is greater than a half ball and used for receiving a connection ball 8 therein, and further, due to being greater than a half ball, the connection ball 8 is unlikely to fall off from the partially-spherical groove 15.

In this embodiment, due to the elastic deformation of the through groove provided at the end of the finger-shaped rod 2 where the sharp end 3 thereof is arranged, the connection ball 8 can be pushed in from outside and snapped within the partially-spherical groove 15 being greater than a half ball, and can also rotate freely while the connection ball 8 is unlikely to fall off from the sharp end of the finger-shaped rod.

The connection ball 8 has a diameter slightly greater than that of the spherical groove 15, as such, the connection ball 8 can be secured within the spherical groove 15 even more steadily and firmly.

As the function in embodiment 1, the connection ball 8 is also provided with an aperture 16 for cooperating with the joining part 7 of the testing part, the joining part 7 of the testing part is inserted into the aperture 16.

For stably attaching the testing part to the sharp end 3, it's further possible to made the joining part 7 of the testing part and the connection ball 8 with materials involving magnet and ferromagnetic materials, respectively, and hence, the joining part 7 and the connection ball 8 may be coupled via magnetic connection.

For the purpose of connecting stably the testing part to the sharp end 3, the joining part 7 of the testing part may also be attached to the aperture 16 in the connection ball 8 through interference fit or snapping connection.

### Embodiment 3

For the sake of simplicity, the advantages identical or similar to that of the connection configuration illustrated in embodiments 1 and 2 are omitted here.

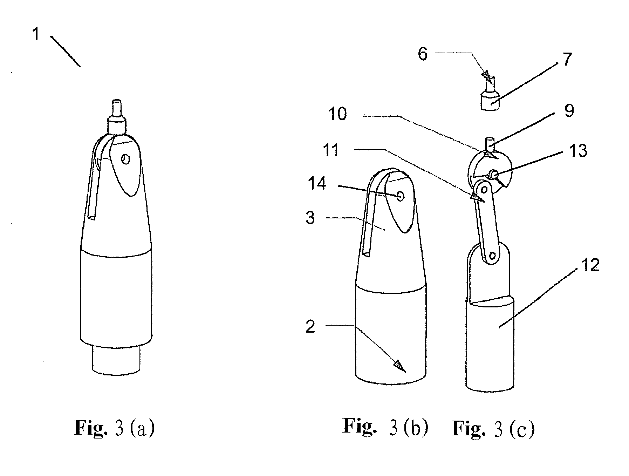

Fig.3(a) illustrates a testing finger 1 attained when the testing part shown in Fig.3(c) and its associated parts are muff-coupled over the finger-shaped rod 2 shown in Fig.3(b).

As shown in Fig.3(b), the finger-shaped rod 2 is hollow, the circular toggle 10 is rotatably attached to the sharp end 3 of the finger-shaped rod 2, a locking pin 13 is provided at the middle of the circular toggle and cooperates with the pin-hole 14 provided at the sharp end 3, the locking pin 13 is provided at the positive and negative sides of the toggle 10, and two pin-holes 14 are also provided correspondingly at the sharp end, the locking pin 13 cooperates with the pin-hole 14 so that the toggle 10 rotates around the radial axle of the sharp end 3 of the finger-shaped rod 2, that is, the toggle 10 rotates around the shaft formed by the locking pin 13 at its positive and negative sides.

A projection 9 is provided at the radial edge of the toggle 10 to cooperate with the testing part, the joining part 7 of the testing part is muff-coupled over the projection 9, the toggle 10 is connected with one end of the driver shaft 11, the other end of the driver shaft 11 is rotatably connected with the slide bar 12, and the motion of the slide bar 12 drives the toggle 10 to rotate via the motion of the driver shaft 11, hence the orientation of the testing part may be altered.

A portion of the slide bar 12 and the Driver shaft 11 are housed within the finger-shaped rod 2, and the slide bar 12 extends beyond the end of the finger-shaped rod 2.Such a configuration reduces the whole volume of the testing finger, and the user may touch the end of the slide bar 12 extending beyond the finger-shaped rod 12, thus it's easy to effectively control the orientation of the testing part by operating the slide bar 12.

With the present configuration, the slide bar 12 may also be operated to alter the orientation of the testing head, thus further improve the flexibility when the testing finger is in use comparing with the embodiments 1 and 2.

In order for a stable connection between the testing part and the sharp end 3, it's also possible to connect the joining part 7 of the testing part with the projection 9 via magnetic connection.

Still for the purpose of connecting stably the testing part to the sharp end 3, the joining part 7 of the testing part may also be attached to the projection 9 through interference fit or snapping connection.

In this embodiment, the free end of the slide bar 12 may also threadly fit with the free end of the finger-shaped rod. When a thread fitting is used to control the sliding of the slide bar 12, it's possible for the slide bar 12 to slide even more smoothly, thus it's more easily to control the motion of the toggle 10 driven by the slide bar 12.

Although generally being applicable in the electric apparatus, the testing finger submitted by the present utility model may also be used in other applications as required. and the description of specific embodiments herein is merely illustrative rather than restrictive description.

The technical features in the above specific embodiments may be combined with or replaced by each other when being applicable.

The above provides detail introduction of the present utility model, and the variations made by the skilled in this art based on the idea of the embodiment of the present utility model about particular embodiments and the range of application should not be construed as departing from the protective scope of the present utility model, and generally speaking, the content of this specification should not be regarded as restriction to the present utility model.

## Claims

1. A testing finger comprising a finger-shaped rod (2), **characterised in that** a sharp end (3) of the finger-shaped rod (2) is connected with a testing part used for measuring a distance.

2. The testing finger according to claim 1, **characterised in that** the testing part is a group of testing heads, and the length of each testing head corresponds to minimum safe distances at different voltage levels in intrusion protection.

3. The testing finger according to claim 1, **characterised in that** the testing part comprises a joining part (7)for connecting with the sharp end (3) of the finger-shaped rod (2) and a calibration value part (6) for measuring a distance.

4. The testing finger according to claim 3, **characterised in that** the sharp end (3) of the finger-shaped rod (2) is provided with a partially-spherical groove (15), the bottom of the partially-spherical groove (15) is securely provided with a magnet (4), and the partially-spherical groove (15) is provided therein with a connection ball (5) made of ferromagnetic materials, the connection ball (5) is attached into the partially-spherical groove (15) via the magnetic connection by the magnet (4), and the connection ball (5) is provided with an aperture (16) cooperating with the joining part (7) of the testing part, and the joining part (7) of the testing part is inserted into the aperture (16).

5. The testing finger according to claim 3, **characterised in that** the end of the finger-shaped rod (2) where the sharp end (3) is located is provided at the centre thereof with a groove (17) extending to the outer edge of the finger-shaped rod (2), and the sharp end (3) of the finger-shaped rod (2) is provided with a partially-spherical groove (15) greater than a half ball, and within the partially-spherical groove (15), there is provided with a connection ball (8) having a diameter slightly greater than the diameter of the spherical groove, the connection ball (8) is provided with an aperture (16) cooperating with the joining part (7) of the testing part, and the joining part (7) of the testing part is inserted into the aperture (16).

6. The testing finger according to claim 5, **characterised in that** the bottom of the groove (15) is transited by a cylindrical groove (18), the diameter of which is greater than the width of the groove (15).

7. The testing finger according to any one of claims 4-6, **characterised in that** the joining part (7) of the testing part is attached with the aperture (16) of the connection ball (8) through interference fit, snapping connection or magnetic connection.

8. The testing finger according to claim 3, **characterised in that** the finger-shaped rod (2) is hollow, the sharp end (3) of the finger-shaped rod (2) is rotatably connected to the circular toggle (10), the toggle (10) rotates around the radial axle of the sharp end (3) of the finger-shaped rod (2), and the radial edge of the toggle (10) is provided with a projection (9) for cooperating with the testing part, the joining part (7) of the testing part is muff-coupled onto the projection (9), the toggle (10) is connected with one end of the driver shaft (11), and the other end of the driver shaft (11) is rotably coupled with the slide bar (12), and the driver shaft (11) and part of the slide bar (12) are housed within the finger-shaped rod (2), the slide bar (12) extends beyond the end of the finger-shaped rod (2).

9. The testing finger according to claim 8, **characterised in that** the joining part (7) of the testing part is attached with the projection (9) through interference fit, snapping connection or magnetic connection.

10. The testing finger according to claim 8 or 9, **characterised in that** the free end of the slide bar (12) is screw fitted with the free end of the finger-shaped rod (2).
